# EUROPÄISCHE PATENTSCHRIFT

(11) **EP 0 668 716 B1**
(45) Veröffentlichungstag und Bekanntmachung des Hinweises auf die Patenterteilung: **18.09.1996**
(21) Anmeldenummer: 95250040.3
(22) Anmeldetag: 15.02.1995
(51) Int. Cl.: H05K 9/00

(54) **Metallgehäuse für den Einbau elektronischer Bauteile**
Metal housing for electronic components
Boîtier métallique pour composants électroniques

(30) Priorität: 21.02.1994 DE 4405408
(43) Veröffentlichungstag der Anmeldung: 23.08.1995
(73) Patentinhaber: ROLEC Gehäuse-Systeme Rose + Rose GmbH & Co. KG, D-31737 Rinteln/Weser (DE)
(72) Erfinder: Rose, Friedhelm, D-32457 Porta Westfalica (DE); Rose, Matthias, D-31737 Rinteln (DE)
(74) Vertreter: Brümmerstedt, Hans Dietrich, Dipl.-Ing.

(56) Entgegenhaltungen:
- EP-A- 0 392 905
- DE-A- 3 612 975
- DE-U- 7 115 306
- DE-U- 9 206 130
- WESCOM 83, Bd. 27, 1983 North Hollywood,US; Seiten 1-4, GROVER BOOTHMAN:"Designing business machines for emi shielding"
- DESIGN ENGENEERING, Juni 1992 London,GB; Seiten 33+-36, "Design of enclosures to reduce em interference"

## Beschreibung

Die vorliegende Erfindung betrifft ein Metallgehäuse für den Einbau elektronischer Bauteile, das im wesentlichen aus einem Gehäuseunterteil und einem Deckel besteht, wobei der Deckel eine von einem Innenrand und von eimem Aussenrand des Deckels begrenzte umlaufende Nut mit innenliegender Dichtung besitzt, und bei geschlossenem Deckel eine am Gehäuseunterteil vorgesehene, umlaufende Feder in die Nut eingreifend gegen die Dichtung gepreßt ist. Obwohl, da dies der Regelfall ist, hier und auch nachstehend von der Anordnung der Nut im Deckel und der Feder am Gehäuseunterteil ausgegangen wird, versteht es sich von selbst, daß sich die gleiche Wirkung natürlich auch bei umgekehrter Anordnung, d.h. bei der Nut im Gehäuseunterteil und der Feder am Deckel einstellt.

Die oben beschriebene Abdichtung der Schließfuge zwischen Deckel und Gehäuseunterteil ist erforderlich, damit die empfindliche Elektronik nicht durch in den Gehäuseinnenraum eindringenden Staub oder durch eindringende Flüssigkeit in ihrer Funktion beeinträchtigt oder sogar zerstört wird. Durch eine Verschraubung des Deckels mit dem Unterteil oder durch einen entsprechenden Schnellverschluß ist sichergestellt, daß das Gehäuse wirklich dicht verschlossen ist.

Neben dieser Abdichtung gegen Staub und Feuchtigkeit müssen diese Gehäuse auch gegen elektrische und magnetische Störfelder abgeschirmt sein. An diese Abschirmung werden zunehmend höhere Anforderungen gestellt, da aufgrund der rasanten Entwicklung auf dem Gebiet der Elektronik, insbesondere der Mikroelektronik, die Zahl der eingesetzten Geräte und damit die Wahrscheinlichkeit der gegenseitigen Beeinflussung durch unerwünschte Ein- bzw. Ausstrahlung ständig wächst.

Die Abschirmung ist bekanntermaßen umso wirksamer, je besser die elektrische oder magnetische Leitfähigkeit des Abschirmmaterials, je größer die Materialstärke und je geschlossener der Abschirmkörper ist.

Nach dem Stand der Technik kommen meistens Aluminiumgehäuse zum Einsatz, weil Aluminium elektromagnetische Strahlung im ausreichenden Maße absorbiert. Eine Problemzone ist dabei, natürlich aber auch bei Gehäusen aus anderen Werkstoffen, die notwendige Schließfuge zwischen Deckel und Gehäuseunterteil, da diese eine Unterbrechung der leitenden Verbindung zwischen Deckel und Gehäuseunterteil darstellt. Eine gewisse Abhilfe schafft hier eine kontaktierende Ausbildung der Schraubverbindung zwischen Deckel und Gehäuseunterteil, jedoch reicht diese Maßnahme insbesondere im höheren Frequenzbereich nicht aus, so daß für eine wirksame Abschirmung weitere Vorkehrungen getroffen werden müssen.

Diese Vorkehrungen bestehen nach dem Stand der Technik darin, daß leitfähige, teure Dichtungen eingesetzt und Nuten und Federn lackfrei gehalten werden.

Es sind weiterhin auch Gehäuse bekannt, wie z.B. das in der DE-PS 36 12 975 offenbarte, bei dem der die Nut begrenzende Dekkelaußenrand außer auf dem Gehäuseunterteil aufliegt, dort also ein an sich leitender Metall-auf-Metall-Kontakt vorliegt. Nachteilig an dieser Lösung ist, daß dieser Bereich nicht vor Korrosion geschützt ist. Somit besteht schon nach kurzer Zeit die Gefahr, daß dieser Kontakt verloren geht und damit keine ausreichende Abschirmung mehr gegeben ist. Außerdem ist es sehr aufwendig, diesen Bereich lackfrei zu halten, da es in der Regel wünschenswert ist, die äußere Gehäuseoberfläche aus Korrosionsschutzgründen und aus dekorativen Gründen zu lackieren. Daher ist nach dem Stand der Technik die Verwendung von leitenden Dichtungen mit lackfreier Nut und Feder letztlich die einzig wirksame Maßnahme. Da es aber trotzdem an der Feder zu Korrosionen kommen kann, ist auch diese Lösung nur begrenzt wirksam.

Weitere gegen umwelteinflüsse geschützte sowie elektromagnetisch abgeschirmte Gehäuse sind in DE-U-92 06 130 und DE-U-71 15 306 angegeben.

Aufgabe der vorliegenden Erfindung ist es daher, ein Gehäuse für den Einbau elektronischer Bauteile zur Verfügung zu stellen, bei dem durch einfache konstruktive Mittel eine wirksame Abschirmung der Schließfuge zwischen Gehäuseunterteil und Deckel gegeben ist.

Erfindungsgemäß wird diese Aufgabe dadurch gelöst, daß die Stirnfläche des Innenrandes bei geschlossenem Deckel leitend auf dem Gehäuseunterteil aufliegt, während der Außenrand und das Gehäuseunterteil unter Bildung eines Spaltes kontaktfrei bleiben.

Aufgrund dieser Lösung wird bei geschlossenem Deckel auf der Gehäuseinnenseite ein leitender Kontakt zwischen Deckel und Gehäuseunterteil hergestellt. Dieser Kontakt ist vor korrosiven Einflüssen geschützt, so daß für die meisten Anwendungsfälle auf teure, leitfähige Dichtungen verzichtet werden kann.

Ein weiterer Vorteil ist darin zu sehen, daß das Gehäuse nunmehr ohne weiteres im geschlossenen Zustand lackiert werden kann, denn der zwischen Deckel und Gehäuseunterteil auf der Außenseite verbleibende Spalt gewährleistet, daß beide Teile durch den Lack nicht verkleben bzw. zusammenbacken. Gleichzeitig werden durch das Lackieren des Gehäuses im geschlossenen Zustand die Kontaktflächen zwischen Nut und Feder auf einfache Weise lackfrei gehalten. Das ist von Vorteil, wenn für spezielle Anwendungen zusätzlich zu der erfindungsgemäßen Maßnahme noch eine leitfähige Dichtung verwendet wird.

In weiterer Ausgestaltung der Erfindung sind zwischen Gehäuseunterteil und Deckel punktförmige Kontakte vorgesehen. Dadurch wird die Intensität des Kontaktes erhöht, da an den punktförmigen Kontaktstellen im Vergleich zum Vollflächenkontakt eine wesentlich höhere Flächenpressung vorliegt.

Die Erfindung wird nachstehend anhand eines Ausführungsbeispiels näher erläutert. In der dazugehörigen Zeichnung zeigt:

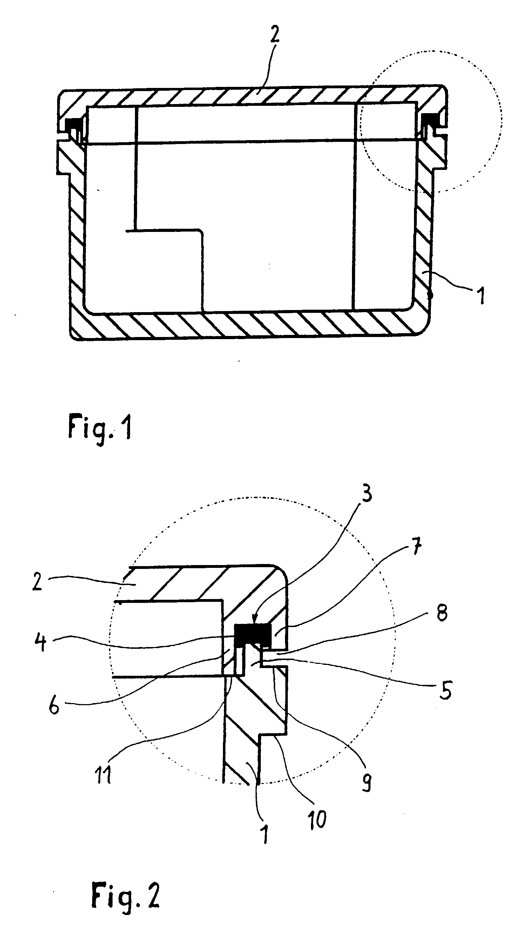

- Fig. 1: einen schematischen Schnitt durch ein erfindungsgemäß ausgeführtes Gehäuse, und
- Fig. 2: eine vergrößerte Einzelheit nach Fig. 1.

Das Gehäuse besteht aus einem Gehäuseunterteil 1 und einem Deckel 2. Die Verschraubung des Deckels 2 mit dem Gehäuseunterteil 1 liegt in den Gehäuseecken und ist, da sie von den üblichen Verschraubungen nicht abweicht, nicht dargestellt.

Der Deckel 2 weist eine umlaufende Nut 3 auf, in die eine nicht-leitende Gummi- oder Kunststoffdichtung 4 eingelegt ist, und die vom Innenrand 6 und Außenrand 7 des Deckels 2 begrenzt ist.

Auf dem Schließrand des Gehäuseunterteils 2 ist eine umlaufende Feder 5 vorgesehen, zu der die Innenwand des Gehäuseunterteils 1 einspringt, wodurch eine umlaufende Kontaktfläche 11 gebildet ist. Im dargestellten, verschraubten Zustand des Gehäuses liegt die Stirnfläche des Innenrandes 6 fest auf der Kontaktfläche 11 auf. Dabei ist durch die Stärke des Anziehens der Schrauben der Anpreßdruck zwischen der Stirnfläche des Innenrandes 6 und der Kontaktfläche 11 festgelegt, da andere Kontaktstellen zwischen dem Deckel 2 und dem Gehäuseunterteil 1, abgesehen vom flexiblen Kontakt zwischen Feder 5 und Dichtung 4, nicht bestehen. Die Höhe des Innenrandes 6 ist so gewählt, daß in seinem Zusammenspiel mit den anderen Elementen der Schließfuge eine genügende Pressung der Dichtung 4 erfolgt.

Während der Innenrand 6 das Gehäuseunterteil 1 auf der Kontaktfläche 11 kontaktiert, verbleibt zwischen dem Außenrand 7 und dem Gehäuseunterteil 1 ein Spalt 8, der zwischen der Stirnwand des Außenrandes 7 und einer von der Feder 5 auf die Höhe der Dekkelaußenwand nach außen springenden Fläche 9 gebildet ist. Die Kontaktfläche 11 liegt tiefer als die Fläche 9. Die dadurch gebildete Überlappung zwischen Deckel 2 und Gehäuseunterteil 1 wirkt sich zusätzlich positiv auf die Abschirmwirkung aus.

Kurz unterhalb der Fläche 9 springt die Außenwand des Gehäuseunterteils 1 aus Gründen der Materialersparnis wieder auf eine geringere Wandstärke ein. Dadurch wird die Fläche 10 gebildet, die als Auflagefläche beim Einbau des Gehäuses in Schalttafeln dient.

Anstelle eines horizontalen Spaltes kann auch ein vertikaler Spalt zwischen der Außenwand des Gehäuseunterteils 1 und der Innenwand des Außenrandes 7 vorgesehen werden.

Es ist natürlich auch möglich, die Wandstärke des Gehäuseunterteils 1 durchgehend auf der Seitenwandstärke des Deckels 2 zu belassen, oder aber die Wandstärke des Gehäuseunterteils 1 nicht nach außen, sondern nach innen vorspringen zu lassen.

## Patentansprüche

1. Metallgehäuse für den Einbau elektronischer Bauteile, im wesentlichen bestehend aus einem Gehäuseunterteil (1) und einem Deckel (2), wobei der Deckel (2) eine von einem Innenrand (6) und von einem Aussenrand (7) des Deckels begrenzte umlaufende Nut (3) mit innenliegender Dichtung (4) besitzt, und bei geschlossenem Deckel (2) eine am Gehäuseunterteil (1) vorgesehene, umlaufende Feder (5) in die Nut (3) eingreifend gegen die Dichtung (4) gepreßt ist, dadurch gekennzeichnet, daß die Stirnfläche des Innenrandes (6) bei geschlossenem Deckel (2) leitend auf dem Gehäuseunterteil (1) aufliegt, während der Außenrand (7) und das Gehäuseunterteil (1) unter Bildung eines Spaltes (8) kontaktfrei bleiben.

2. Metallgehäuse nach Anspruch 1, dadurch gekennzeichnet, daß zwischen dem Innenrand (6) und dem Gehäuseunterteil (1) punktförmige Kontakte bestehen.

## Claims

1. Metal housing for electronic components, substantially consisting of a bottom part (1) of a housing and a lid (2), the lid (2) having a circumferential groove (3) being delimited by an internal rim (6) and an external rim (7) of the lid and the lid (2) being provided with seal (4) lying on the inside, and where, with the lid (2) closed, a circumferential spring (5) provided at the bottom part (1) of the housing is pressed against the seal (4) while meshing with the groove (3) characterised in that the front area of the internal rim (6) lies in a conductive manner on the bottom part (1) of housing when the lid (2) is closed while the outer rim (7) and the bottom (1) of the housing remain free of contact while forming a slot (8).

2. Metal housing according to claim 1 characterised in that there are point-like contacts between the internal rim (6) and the bottom part (1) of the housing.

## Revendications

1. Boîtier métallique pour l'installation de composants électroniques se composant essentiellement d'une partie inférieure (1) et d'un couvercle (2), le couvercle (2) présentant tout autour une rainure (3) garnie d'un joint imperméable (4) et limitée par un bord interne (6) et un bord externe (7) et, lorsque le couvercle (2) est fermé, un ressort (5) prévu tout autour sur la partie inférieure (1), étant pressé dans la rainure (3) en appuyant contre le joint (4), caractérisé en ce que, lorsque le couvercle (2) est fermé, la face frontale du bord interne (6) repose en assurant la conductibilité électrique sur la partie inférieure (1), alors que le bord externe (7) et la partie inférieure (1) demeurent sans contact en formant une fente (8).

2. Boîtier métallique suivant la revendication 1, caractérisé en ce qu'entre le bord interne (6) et la partie inférieure (1), il y a des contacts ponctuels.
